# EUROPÄISCHE PATENTSCHRIFT

(11) **EP 2 918 153 B1**
(45) Veröffentlichungstag und Bekanntmachung des Hinweises auf die Patenterteilung: **29.11.2017**
(21) Anmeldenummer: 13779584.5
(22) Anmeldetag: 21.10.2013
(51) Int. Cl.: H05K 7/14, H01R 9/26

(54) **VORRICHTUNG ZUM STEUERN UND/ODER REGELN EINER TECHNISCHEN ANLAGE**
DEVICE FOR CONTROLLING AND/OR REGULATING A TECHNICAL SYSTEM
DISPOSITIF DE COMMANDE ET/OU RÉGLAGE D'UNE INSTALLATION TECHNIQUE

(30) Priorität: 08.11.2012 DE 102012110698
(43) Veröffentlichungstag der Anmeldung: 16.09.2015
(73) Patentinhaber: Pilz GmbH & Co. KG, 73760 Ostfildern (DE)
(72) Erfinder: GRUBER, Winfried, 73728 Esslingen (DE)
(74) Vertreter: Witte, Weller & Partner Patentanwälte mbB
(86) Internationale Anmeldenummer: PCT/EP2013/071922
(87) Internationale Veröffentlichungsnummer: WO 2014/072162

(56) Entgegenhaltungen:
- EP-A1- 1 511 054
- EP-A1- 1 764 873
- DE-A1- 19 651 961
- US-A- 5 510 960
- US-A1- 2011 164 350

## Beschreibung

Die vorliegende Erfindung betrifft eine Vorrichtung zum Steuern und/oder Regeln einer technischen Anlage, mit einem ersten, einem zweiten und zumindest einem dritten Backplanemodul, die nebeneinander auf einer Tragschiene, die eine Längsrichtung definiert, positionierbar sind, wobei das erste Backplanemodul einen ersten Grundkörper und ein erstes Kontaktteil besitzt, wobei das zweite Backplanemodul einen zweiten Grundkörper und ein zweites Kontaktteil besitzt, und wobei das dritte Backplanemodul einen dritten Grundkörper und ein drittes Kontaktteil besitzt, wobei die Grundkörper jeweils eine Oberseite mit Einstecköffnungen haben, in die elektrische Kontakte von separaten Elektronikmodulen einsteckbar sind, und wobei die Kontaktteile eine Busleitung in der Längsrichtung bilden, über die eingesteckte Elektronikmodule elektrisch miteinander koppelbar sind.

Eine Vorrichtung dieser Art ist aus der Beschreibung "PSSuniversal, Programmable Control Systems PSS®, System Description, No. 21256-EN-04" der Anmelderin bekannt.

Eine Vorrichtung im Sinne der vorliegenden Erfindung kann insbesondere Bestandteil von bzw. Basis für eine modulare konfigurierbare oder programmierbare Steuerung sein, wobei die Elektronikmodule Eingänge zum Anschließen von Sensoren, Ausgänge zum Anschließen von Aktoren und/oder Daten- und Signalverarbeitungsschaltkreise zum Verarbeiten der Sensorsignale und zum Erzeugen von Steuersignalen für die Aktoren besitzen.

Insbesondere stellt PSSuniversal® eine modulare programmierbare Steuerung für Standard- und Sicherheitsaufgaben bereit. Eine Modulanordnung weist hier ein erstes Modul in Form eines Elektronikmoduls und ein zweites Modul in Form eines sogenannten Basismoduls auf. Das Elektronikmodulteil wird durch eine geradlinige Bewegung auf das Basismodul gesteckt. Die nebeneinander angeordneten Basismodule bilden eine Busleitung und können auch als Backplanemodule bezeichnet werden.

Das Elektronikmodul gibt es in diesem bekannten System in verschiedenen Varianten. In einer ersten Variante kann das Elektronikmodul ein Ein-/Ausgabemodul sein, also ein Modul mit Eingängen zum Anschluss von Sensoren und/oder mit Ausgängen zum Anschluss von Aktoren. Das Elektronikmodul leitet in so einem Fall die Sensordaten über die Busleitung an eine entfernte Speicherprogrammierbare Steuerung weiter, und/oder es empfängt von der Speicherprogrammierbaren Steuerung über die Busleitung Steuerdaten, die es in Form von Steuersignalen an die Aktoren ausgibt. In einer zweiten Variante kann das Elektronikmodul ein Spannungsversorgungsmodul, auch als Einspeisemodul bezeichnet, sein. Das Spannungsversorgungsmodul dient zur externen Einspeisung einer Module Supply, d.h. einer Versorgungsspannung für die nachfolgenden Elektronikmodule, und/oder zur Einspeisung einer Periphery Supply, d.h. einer Versorgungsspannung, die an die Sensoren und/oder Aktoren geführt ist. Mit Hilfe der Einspeisemodule können mehrere Potenzialgruppen gebildet werden und es ist insbesondere möglich, hohe Laststromanforderungen flexibel zu erfüllen.

Für die erste Variante des Elektronikmodul (Ein-/Ausgabemodul) wird ein Basismodul benötigt, das in beiden Richtungen (nach rechts und nach links) der Längsrichtung Busanschlüsse aufweist, um die Daten und auch die Versorgungsspannung von dem links danebenliegenden Modul auf das rechts danebenliegende Modul durchzuschalten. Diese Variante wird daher auch Bauart mit durchgeschaltetem Bus genannt. Für die zweite Variante (Spannungsversorgungsmodul) wird ein spezielles Basismodul benötigt, das in eine erste Richtung (z.B. nach links) keine Verbindung zum Versorgungsspannungsbus aufweist und in die andere Richtung (z.B. nach rechts) eine Verbindung zum Versorgungsspannungsbus aufweist, um die Versorgungsspannung nur an die rechts danebenliegenden Module weiterzuleiten. Das heißt, bei Bildung einer neuen Potenzialgruppe muss die Verbindung auf dem Versorgungsspannungsbus durch ein spezielles Basismodul aufgetrennt werden. Diese Variante wird daher auch Bauform mit aufgetrenntem Bus genannt.

Eine Steuerungsvorrichtung mit einem Modul bestehend aus drei Modulteilen ist beispielsweise durch das X20-System von Bernecker & Rainer Industrieelektronik Ges. m.b.H. mit Sitz in 5142 Eggelsberg, Österreich bekannt, wie aus der Beschreibung "X20-System, User's Manual, Version: 2.10 (May 2009), Model number: MAX20-ENG" ersichtlich. Ein Modul beinhaltet hier ein erstes Modulteil in Form eines Elektronikmodulteils, ein zweites Modulteil in Form eines Basismodulteils und ein drittes Modulteil in Form eines Feldklemmenmodulteils, oder auch Anschlussmodulteil genannt. Die externen Anschlüsse sind in diesem System in einem separaten Anschlussmodulteil untergebracht.

Auch in diesem System gibt es das Basismodulteil in mehreren Bauformen, insbesondere in einer ersten Bauform mit durchverbundener Versorgung (bezeichnet mit X20BM11) und einer zweiten Bauform mit Auftrennung der Versorgung in eine Richtung *(bezeichnet mit X20BM01). Letztere Bauform dient zur Verbindung mit entsprechenden Spannungsversorgungsmodulteilen. Dadurch können auch in diesem System verschiedene Potenzialgruppen gebildet werden.

Ein Nachteil solcher Steuerungsvorrichtungen ist, dass eine spezielle Bauform des Basismoduls für ein entsprechendes Spannungsversorgungsmodul notwendig ist. Dies erhöht zum einen die Herstellungskosten und zum anderen kann es für den Benutzer kompliziert sein, die passende Bauformen der Module korrekt zusammenzusetzen. Außerdem ist eine Umkonfiguration nur mit Aufwand möglich, da für eine neue Aufteilung der einzelnen Potentialgruppen die gesamte Backplane umgestellt werden muss.

DE 197 10 768 C2 offenbart ein elektrisches oder elektronisches Gerät zum Aufsetzen auf eine Tragschiene, mit einem Gehäuse, mit wenigstens einer im Gehäuse angeordneten Leiterplatte und mit in Längsrichtung der Tragschiene weisenden Kontakten für eine Daten- und/oder Energiebusverbindung mit benachbarten, auf die Tragschiene aufgesetzten und korrespondierende Kontakte aufweisenden Geräten.

DE 19 651 961 A1 offenbart ein elektrisches Gerät mit modularer Aufbautechnik, das in einen Sockelteil und einen Elektronikmodulteil aufgeteilt ist, wobei im Sockelteil im Wesentlichen O- oder Z-förmig ausgebildete Potenzialkontakte angeordnet sind. Die Potenzialkontakte sind nebeneinander angeordnet, sodass immer ein federnder Schenkel eines ersten Potenzialkontaktes einen starren Schenkel eines benachbarten Potenzialkontaktes kontaktiert, um einen autrennbaren Bus zu erzeugen.

EP 1 764 873 A1 offenbart ein modulares Steuerungssystem, das aus Terminamodulen und dazu passenden Funktionsmodulen aufgebaut ist. Das modulare Steuerungssystem verwendet baugleiche Terminalmodule, wobei die unterschiedlichen Funktionalitäten des Steuerungssystems durch zusätzliche Funktionsbausteine bereitgestellt werden. Die einheitlichen Terminalmodule ermöglichen eine gute Übersichtlichkeit hinsichtlich der Einspeisung von Versorgungsspannungen, Potenzialweiterleitung und - trennung.

US 2011/0164350 A1 offenbart ein Steuerungssystem mit einer Vielzahl von Steuereinheiten die nebeneinander angeordnet sind, wobei jede Steuereinheit eine Aufnahme für ein Befestigungselement vorsieht, über das die einzelnen Steuereinheiten zusammengefügt werden können.

Vor diesem Hintergrund ist es eine Aufgabe der vorliegenden Erfindung, eine Vorrichtung der eingangs genannten Art anzugeben, die geringere Herstellungskosten erfordert, eine erhöhte Benutzerfreundlichkeit bereitstellt und sich flexibler umkonfigurieren lässt.

Gemäß einem ersten Aspekt der Erfindung wird diese Aufgabe durch eine Vorrichtung der eingangs genannten Art gelöst, wobei der zweite Grundkörper eine Aufnahme aufweist, an der das zweite Kontaktteil wahlweise in einer von zumindest zwei definierten Varianten angeordnet ist, wobei das zweite Kontaktteil in einer ersten Variante von den zumindest zwei Varianten eine elektrisch leitfähige Verbindung zum ersten Kontaktteil und zum dritten Kontaktteil besitzt, und wobei das zweite Kontaktteil in einer zweiten Variante von den zumindest zwei Varianten eine elektrisch leitfähige Verbindung zu dem dritten Kontaktteil besitzt, nicht jedoch zu dem ersten Kontaktteil, dadurch gekennzeichnet, dass das zweite Kontaktteil eine definierte erste Pose und zumindest eine alternative zweite Pose an der Aufnahme einnehmen kann, wobei die erste Pose die erste Variante bildet und wobei die alternative zweite Pose die zweite Variante bildet, sodass das zweite Kontaktteil je nach Variante an einer von zumindest zwei Positionen und/oder in zumindest zwei verschiedenen Orientierungen angeordnet sein kann, wobei das zweite Kontaktteil einen Kunststoffkörper aufweist, in dem ein erster Metallkontakt und ein zweiter Mefallkontakt zur elektrischen Verbindung mit dem ersten und dritten Kontaktteil eingelassen sind, und wobei der zweite Metallkontakt auf einer dem ersten Metallkontakt abgewandten Seite des Kunststoffkörpers angeordnet ist.

Ferner wird die Aufgabe durch ein Backplanemodul zur Verwendung in einer solchen Vorrichtung gemäß Anspruch 12 gelöst.

Die neue Vorrichtung ist somit eine modular aufgebaute Montagebasis aus zumindest drei Backplanemodulen, die zur Aufnahme von Elektronikmoduten einer modularen Steuerung dienen. Vorzugsweise weist die Vorrichtung mehr als drei Backplanemodule in einer Reihe auf, wobei die hier maßgeblichen drei Backplanemodule an beliebiger Position in der Reihe angeordnet seinen können. Ebenso können die drei Backplanemodule in Längsrichtung oder entgegen der Längsrichtung nebeneinander angeordnet sein. Die Elektronikmodule können auf die Backplanemodule aufgesetzt werden. Die Elektronikmodule sind so über einen Bus miteinander koppelbar, dessen Busleitung durch die Backplanemodule bereitgestellt wird. Im Gegensatz zu Vorrichtungen aus dem Stand der Technik wird hier zumindest ein Teil dieses Busses durch separate Modulteile, nämlich zumindest das variable zweite Kontaktteil, gebildet. In bevorzugten Ausgestaltungen sind jedoch auch die Kontaktteile im ersten und dritten Backplanemodul separate Modulteile, die an den Grundkörpern befestigt sind. Die Kontaktteile bilden eine Reihe mit stückweise aneinandergesetzten Leitungsabschnitten, über die die Bussignale übertragen werden. Das Kontaktteil des zweiten Backplanemoduls weist dabei zwei Varianten auf. In der ersten Variante schaltet das Kontaktteil den Bus durch, d.h. es wird eine elektrisch leitfähige Verbindung vom vorherigen Kontaktteil zum nachfolgenden Kontaktteil hergestellt. In der zweiten Variante trennt das Kontaktteil den Bus auf, d.h. es besteht zwar eine Verbindung vom zweiten Kontaktteil zum nachfolgenden Kontaktteil, jedoch nicht zum vorherigen Kontaktteil.

Durch die Möglichkeit den Bus aufzutrennen, kann dieser in verschiedene Busabschnitte unterteilt werden, die elektrisch voneinander getrennt sind. Einzelne Module können somit zu Gruppen zusammengefasst werden, die einem gemeinsamen Busabschnitt zugeordnet sind. Sollte sich diese Zuordnung ändern, indem neue Module hinzugefügt, getauscht oder entfernt werden, kann der Bus durch Variieren des zweiten Kontaktteils an die neuen Erfordernisse angepasst werden, ohne dass das Backplanemodul ausgetauscht werden muss. Die Gestaltung des Busses wird somit flexibler und gleichzeitig einfacher für einen Benutzer.

Das Auslagern eines Busses in separate Kontaktteile hat darüber hinaus den Vorteil, dass die Kontaktteile den Erfordernissen des Busses angepasst werden können, ohne die Grundkörper der Backplanemodule verändern zu müssen. Beispielsweise treten in einem Versorgungsbus höhere Ströme, und damit verbunden höhere thermische Belastungen, auf als in einem Datenbus, wodurch auch die Anforderungen an die Busstrukturen steigen. Die Busstruktur wird in der neue Vorrichtung jedoch im Wesentlichen durch die Kontaktteile bestimmt und ist somit unabhängig vom Aufbau der Grundkörper der Backplanemodule. Der Grundkörper kann dadurch einfacher ausgelegt sein und ist folglich kostengünstiger in der Herstellung.

Insgesamt ermöglicht die neue Vorrichtung somit geringere Herstellungskosten und erhöhte Benutzerfreundlichkeit bei gesteigerter Flexibilität.

Der zweite Kontaktteil kann eine erste und zumindest eine zweite Pose in der Aufnahme am Grundkörper einnehmen und sich davon abhängig in der ersten oder zweiten Variante befinden. Pose bezeichnet in diesem Zusammenhang die Kombination von Position und Orientierung. Das Kontaktteil kann also je nach Variante an einer von zumindest zwei verschiedenen Positionen und/oder in einer von zumindest zwei verschiedenen Orientierungen an dem Grundkörper angeordnet sein. Die Variante des zweiten Kontaktteils wird somit im Wesentlichen durch die Pose bestimmt und allenfalls nachrangig und bevorzugt gar nicht durch die Ausgestaltung des zweiten Kontaktteils. Das zweite Kontaktteil kann somit für die erste und zweite Variante gleich sein, wodurch Herstellungs-und Lagerkosten reduziert werden können.

Durch das Kunststoffgehäuse ist das zweite Kontaktteil ein robustes eigenständiges Bauteil mit eingelassenen Metallkontakten. Ein solches Bauteil ist leicht als Spritzgussteil zu fertigen und kann kostengünstig in großen Stückzahlen hergestellt werden. Die Kontakte, die vorzugsweise je aus einem einzelnen Metallteil bestehen, werden dabei beim Spritzen des Kunststoffkörpers miteingefasst.

Die oben genannte Aufgabe ist daher vollständig gelöst.

In einer ersten Ausgestaltung weisen der erste und der dritte Grundkörper jeweils eine weitere Aufnahme auf, wobei das erste Kontaktteil und das dritte Kontaktteil an jeweils einer der weiteren Aufnahmen angeordnet sind.

In dieser Ausgestaltung weisen auch das erste und das dritte Backplanemodul an ihren jeweiligen Grundkörpern Aufnahmen für separate Kontaktteile auf, d.h. auch diese Backplanemodule sind modular zusammengesetzt. Vorzugsweise sind der Grundkörper und das Kontaktteil dabei separate Bauelemente, die zusammen ein Backplanemodul bilden. Vorteilhaft bei dieser Ausgestaltung ist, dass die Busstruktur dabei durch separate Bauelemente, nämlich die Kontaktteile, gebildet wird. Die Kontaktteile bilden somit eine modulare Busleitung innerhalb der modularen Backplane. Vorzugsweise sind dabei der erste, zweite und dritte Grundkörper jeweils gleich aufgebaut. Die einheitliche Auslegung der Grundkörper ermöglicht eine kostengünstige Herstellung der Backplanemodule. In einer weiteren Ausgestaltung weist die Vorrichtung ein weiteres
Backplanemodul mit einem weiteren Grundkörper und einem weiteren Kontaktteil auf, wobei das dritte Kontaktteil in Bezug auf das zweite Kontaktteil und das weitere Kontaktteil in gleicher Weise variabel ist, wie das zweite Kontaktteil in Bezug auf das erste Kontaktteil und das dritte Kontaktteil.

In dieser Ausgestaltung wird die Backplane um ein weiteres Backplanemodul, welches neben dem dritten Backplanemodul angeordnet wird, erweitert. Das dritte Kontaktteil kann dabei wie der zweite Kontaktteil wahlweise in mindestens zwei Varianten am dritten Grundkörper angeordnet sein. Abhängig in welcher Variante das dritte Kontaktteil ist, wird der Bus von dem dritten Kontaktteil durchgeschaltet oder unterbrochen, d.h. eine elektrische Leitfähigkeit vom zweiten Kontaktteil zum weiteren Kontaktteil erstellt oder getrennt. Wird der Bus unterbrochen, besteht eine Verbindung vom dritten Kontaktteil zum folgenden weiteren Kontaktteil, jedoch keine Verbindung vom dritten Kontaktteil zum zweiten Kontaktteil. In einer besonders bevorzugten Ausgestaltung können neben dem weiteren Backplanemodul noch weitere Backplanemodule in der Reihe angeordnet werden in Analogie zum ersten weiteren Backplanemodul. Dabei ist das jeweilige vorherige Backplanemodul als ein zweites Backplanemodul ausgebildet mit einem variablen Kontaktteil. Vorteilhaft bei dieser Ausgestaltung ist, dass sich die Backplane und der integrierte modulare Bus beliebig fortsetzen und vergrößern lassen. Vorzugsweise sind die weiteren Backplanemodule, weiteren Grundkörper und weiteren Kontaktteile gleichförmig wie das zweite Backplanemodul, der zweite Grundkörper und der zweite Kontaktteil aufgebaut.

Besonders bevorzugt sind der erste, dritte und jeder weitere Kontaktteil gleichförmig wie das zweite Kontaktteil aufgebaut, sodass an jedem Kontaktteil wahlweise eingestellt werden kann, ob der Bus vom vorherigen zum folgenden Kontaktteil durchgeschaltet werden soll oder nicht. Auf diese Weise wird eine hohe Flexibilität bei der Ausgestaltung der Busstruktur innerhalb der Backplane erreicht. Dies ist besonders vorteilhaft, wenn die Schaltung, und damit verbunden die Anordnung der Elektronikmodule, verändert werden muss, um neue Potentialgruppen zu bilden. Durch Variieren der Kontaktteile können die Busabschnitte auch nachträglich beliebig konfiguriert werden, ohne dass Backplanemodule auf der Tragschiene ersetzt, entnommen oder ausgetauscht werden müssen. Eine einmal befestigte Backplane muss somit auch bei einer Veränderung der Schaltung nicht geändert werden, wodurch Zeit und Kosten gespart werden.

In einer weiteren bevorzugten Ausgestaltung weist die Vorrichtung ein Verriegelungselement auf, mit dem das zweite Kontaktteil an der Aufnahme wahlweise in der ersten Pose oder in der zweiten Pose fixiert werden kann.

In dieser bevorzugten Ausgestaltung kann das zweite Kontaktteil in der jeweiligen Pose an der Aufnahme fixiert werden. Vorzugsweise ist dazu ein beweglicher Stift am Kontaktteil angeordnet, der in der jeweiligen Pose in eine Aussparung am Grundkörper verfahren werden kann und so das Kontaktteil in der jeweiligen Pose arretiert. Die Fixierung verhindert, dass sich das Kontaktteil versehentlich löst oder ungewollt in die andere Pose wechselt.

In einer weiteren bevorzugten Ausgestaltung ist die erste Pose eine erste räumliche Position des zweiten Kontaktteils an der Aufnahme und die zweite Pose eine zweite räumliche Position, in die das zweite Kontaktteil mit einer Translationsbewegung verschiebbar ist.

In dieser bevorzugten Ausgestaltung ist die Aufnahme größer als das zweite Kontaktteil. Der Kontaktteil ist verschiebbar an der Aufnahme angeordnet und kann zwischen mindestens zwei Position hin und her bewegt werden. In der ersten Position ist das Kontaktteil in der ersten Variante. Vorzugsweise schließt dabei die Oberseite des Kontaktteils bündig mit der Oberseite des Grundkörpers ab. Zum Wechseln der Variante wird das Kontaktteil in die zweite Position verschoben, welche vorzugsweise tiefer in der Aufnahme liegt. Das zweite Kontaktteil muss somit zum Ändern der Variante nicht aus der Aufnahme gelöst werden und ist vorzugsweise bereits bei der Auslieferung verliersicher in dieser angeordnet. Ein Wechsel zwischen den Varianten und somit eine Aufteilung des Busses ist besonders einfach. Vorzugsweise erfolgt der Wechsel automatisch durch das Aufstecken eines Elektronikmoduls, welches zwingend das Auftrennen des Busses benötigt. Dies könnte beispielsweise ein Einspeisemodul sein, das durch eine besondere Bauform das Kontaktteil beim Aufstecken verschiebt.

In einer weiteren Ausgestaltung weist die Busleitung eine Anzahl von ersten Adern und eine Anzahl von separaten zweiten Adern auf, wobei die ersten Adern einen Datenbus zum Übertragen von Steuerdaten bilden, und wobei die zweiten Adern eine Stromschiene zum Verteilen einer Versorgungsspannung bilden, wobei die zweiten Adern durch die Kontakteile laufen, während die ersten Adern entfernt von den Kontaktteilen in dem Grundkörper angeordnet sind.

In dieser Ausgestaltung ist der Bus in zwei Funktionsgruppen unterteilt, nämlich zum einem in einen Datenbus und zum anderen in einen Versorgungsbus, die in unterschiedlicher Weise in oder an den Backplanemodulen geführt sind. Ein Datenbus weist dabei anderer Anforderungen auf als ein Versorgungsbus. Im ungünstigsten Fall beeinflusst ein Versorgungsbus den Datenbus oder umgekehrt, beispielsweise durch das ungewollt Induzieren einer Spannung in den Datenbus. Weiterhin ist der Datenbus vorzugsweise nicht auftrennbar, während der Versorgungsbus mit Hilfe der Kontaktteile zum Einrichten von verschieden Potentialgruppen in Busabschnitte unterteilbar ist. Die Aufteilung der Busse, insbesondere das Auslagern des Versorgungsbusses in eine separate modulare Struktur, schafft die nötige Flexibilität und erhöht gleichzeitig die sichere Kommunikation auf dem Datenbus.

In einer weiteren Ausgestaltung ist zumindest das zweite Kontaktteil zerstörungsfrei lösbar an der Aufnahme angeordnet.

In dieser Ausgestaltung lässt sich das zweite Kontaktteil aus der Aufnahme lösen und ersetzten. Vorzugsweise ist das Kontaktteil dazu in der Aufnahme wie ein Stecker eingesteckt. Dies ist besonders vorteilhaft, wenn ein Kontaktteil einen Defekt aufweist und ausgetauscht werden muss.

In einer weiteren Ausgestaltung besitzt der zweite Grundkörper eine definierte Breite in Längsrichtung, wobei sich das zweite Kontaktteil im Wesentlichen über die definierte Breite erstreckt.

In diesem Ausführungsbeispiel ist das zweite Kontaktteil nahezu genauso breit wie der zweite Grundkörper. Vorzugsweise berührt das zweite Kontaktteil dabei das erste und das dritte Kontaktteil der Nachbarmodule. Auf einer Seite des Kontaktteils ragen vorzugsweise elektrische Kontakte in Form von Kontaktmessern zum Herstellen einer elektrischen Verbindung über die Einhüllenden des Grundkörper hinaus. Auf der gegenüberliegenden Seite weist das zweite Kontaktteil Gegenkontakte auf, in die nach außen vorstehende Kontaktmesser des benachbarten Kontaktteils eingreifen können. Die Gegenkontakte ragen vorzugsweise nicht aus der Einhüllenden des Grundkörpers hervor, sondern sind in das Kontaktteil eingelassen. Vorteilhaft bei dieser Ausgestaltung ist, dass der zweite Kontaktteil unmittelbar mit dem ersten und dem dritten Kontaktteil verbunden werden kann und die maßgeblichen Kontakte dafür am Kontaktteil selbst angeordnet sind. Dies ermöglicht eine einfache Montage einer robusten modularen Stromschiene, die allein aus den Kontaktteilen aufgebaut ist. Zudem ermöglicht diese Ausgestaltung relative große Kontakte mit geringen Übergangswiderständen sowie eine gute thermische Ableitung.

In einer weiteren Ausgestaltung bilden zumindest zwei der Grundkörper eine integrierte bauliche Einheit.

In dieser Ausgestaltung bestehen zumindest zwei der Grundkörper "aus einem Stück". In bevorzugten Ausführungsbeispielen sind die "einstückigen" Grundkörper ein einzelnes Spritzgussteil, das die Funktionen von zumindest zwei Grundkörpern bereitstellt. Eine Quantelung mit jeweils vier Grundkörpern, die eine integrierte bauliche Einheit bilden, hat sich dabei als besonders bevorzugt in der Praxis herausgestellt, um schnell große Backplanes zusammenzubauen. Vorteilhaft gibt es darüber hinaus weitere Backplanemodule, die nur die Funktion und Baubreite eines einzelnen Grundkörpers besitzen. Backplanemodule verschiedener Baubreite können vorteilhaft miteinander kombiniert werden, um flexibel große Backplanes schnell zusammenzufügen.

In einer weiteren Ausgestaltung weist das zweite Kontaktteil einen Kunststoffkörper auf, der vollständig innerhalb der Aufnahme angeordnet ist.

Die Aufnahmen können prinzipiell Steckplätze an einem freien Ende des Grundkörpers sein, beispielsweise mit Einsteck-, Klemm- und/oder Rastelementen, an denen die Kontaktteile von mehreren Seiten zugänglich befestigt sind oder befestigt werden können. In der hiesigen Ausgestaltung sind die Aufnahmen jedoch Ausnehmungen bzw. Öffnungen in dem Grundkörper, in denen die Kontaktteile gewissermaßen versenkt sind. Der zweite Kontaktteil wird in dieser Ausgestaltung geschützt und robust innerhalb der Aufnahme angeordnet, so dass der Kunststoffkörper des Kontaktteils nicht über die Einhüllende des Grundkörpers hinausragt. Der Grundkörper umfasst das zweite Kontaktteil und schützt es so vor Schäden bei der Montage von Elektronikmodulen. Zusätzlich werden unnötige Kanten vermieden.

In einer weiteren Ausgestaltung weist die Vorrichtung ein erstes und zumindest ein zweites Elektronikmodul auf, die wahlweise auf die Grundkörper aufsteckbar sind, wobei das erste Elektronikmodul erste elektrische Kontakte und das zweite Elektronikmodul zweite elektrische Kontakte aufweist, wobei die ersten elektrischen Kontakte so ausgebildet sind, dass sie das zweite Kontaktteil im aufgesteckten Zustand nur in der ersten Variante elektrisch kontaktieren können, während die zweiten elektrischen Kontakte so ausgebildet sind, dass sie das zweite Kontaktteil im aufgesteckten Zustand nur in der zweiten Variante elektrisch kontaktieren können.

In dieser Ausgestaltung ist das erste Elektronikmodul vorteilhaft ein Logikmodul, insbesondere ein E/A-Modul zum elektrischen Anschluss von Sensoren und/oder Aktoren, und das zweite Elektronikmodul ist ein Einspeisemodul zum Einspeisen einer Versorgungsspannung in den Bus, der durch die Kontaktteile gebildet wird. Das erste Elektronikmodul, welches ein Abnehmer des Busses im Sinne eines Verbrauchers ist, ist in dieser Ausgestaltung so ausgelegt, dass es den Bus nur kontaktiert, wenn das zughörige zweite Kontaktteil in der ersten Variante und somit mit dem vorherigen Busabschnitt verbunden ist. Das zweite Elektronikmodul, welches eine Versorgungspannung in den Bus einspeist, eröffnet eine neue Potentialgruppe in Längsrichtung und darf daher nicht mit dem vorherigen Busabschnitt verbunden sein. Das zugehörige zweite Kontaktteil ist folglich in der zweiten Variante und getrennt von dem vorherigen Busabschnitt.

Vorzugsweise sind die Elektronikmodule so ausgelegt, dass sie auch mechanisch nicht auf die Backplanemodule aufgesetzt werden können bzw. die elektrischen Kontakte nicht mechanisch mit den Gegenkontakten verbunden werden, wenn die Kontaktteile in der falschen Variante für das entsprechende Elektronikmodul sind. Diese Ausgestaltung ist besonders vorteilhaft, um eine Verwechselung oder Fehlbestückung zu vermeiden, die zu einer Beschädigung der Vorrichtung führen könnten. Besonders bevorzugt sind dabei Elektronikmodule, die automatisch beim Aufstecken durch eine spezielle Form des Gehäuses oder der elektrischen Kontakte den jeweiligen zweiten Kontaktteil in die richtige Variante versetzen.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Ausführungsbeispiele der Erfindung sind in der Zeichnung dargestellt und werden in der nachfolgenden Beschreibung näher erläutert. Es zeigen:
- Fig. 1: eine vereinfachte Darstellung einer technischen Anlage mit einem Aus-führungsbeispiel der Vorrichtung,
- Fig. 2: eine perspektivische Darstellung eines Ausführungsbeispiels der Vor-richtung mit mehreren nebeneinander angeordneten Backplanemodulen,
- Fig. 3: eine perspektivische Darstellung des Ausführungsbeispiels der Vorrich-tung nach Fig. 2 mit zusätzlichen Elektronikmodulen auf den Back-planemodulen,
- Fig. 4: eine perspektivische Darstellung eines Ausführungsbeispiels mehrerer Backplanemodule mit einer Querschnittsdarstellung durch die Kontakt-teile,
- Fig. 5: eine perspektivische Darstellung eines Ausführungsbeispiels mit vier Backplanemodulen in einer integrierten Einheit,
- Fig. 5a: eine perspektivische Darstellung eines einzelnen Backplanemoduls,
- Fig. 6: eine perspektivische Darstellung eines zweiten Kontaktteils,
- Fig. 7: eine schematische Darstellung eines Ausführungsbeispiels mit zweiten Kontaktteilen in der ersten und zweiten Variante,
- Fig. 7a: eine schematische Darstellung eines weiteren Ausführungsbeispiels,
- Fig. 7b: eine schematische Darstellung eines weiteren Ausführungsbeispiels, und
- Fig. 8: eine perspektivische Darstellung eines einzelnen zweiten Backplanemoduls mit einem Elektronikmodul.

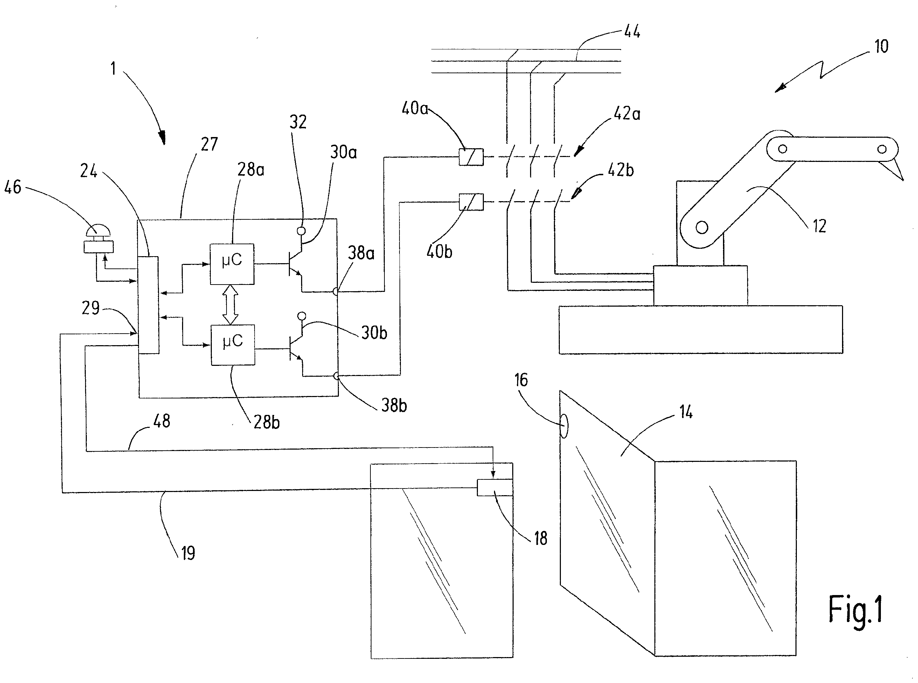

In Fig. 1 ist eine technische Anlage 10 mit einem Ausführungsbeispiel der neuen Vorrichtung 1 zum Steuern und/oder Regeln (auch genannt Steuerungsvorrichtung zum automatisierten Steuern) der technischen Anlage 10 dargestellt. In diesem Ausführungsbeispiel ist die Vorrichtung 1 geeignet zum fehlersicheren Abschalten der Anlage 10, d.h. die Steuerungsvorrichtung 1 wird für Sicherheitsaufgaben verwendet. Die Anlage 10 beinhaltet hier beispielhaft einen Roboter 12, von dessen Bewegungen im Arbeitsbetrieb eine Gefahr für Personen ausgeht, die sich im Arbeitsbereich des Roboters 12 aufhalten. Aus diesem Grund ist der Arbeitsbereich des Roboters 12 mit einem Schutzzaun mit einer Schutztür 14 abgesichert. Die Schutztür 14 ermöglicht den Zugang in den Arbeitsbereich des Roboters 12, beispielsweise für Wartungsarbeiten oder für Einrichtarbeiten. Im normalen Arbeitsbetrieb darf der Roboter 12 jedoch nur arbeiten, wenn die Schutztür 14 geschlossen ist. Sobald die Schutztür 14 geöffnet wird, muss der Roboter 12 abgeschaltet werden oder auf andere Weise in einen sicheren Zustand gebracht werden.

Um den geschlossenen Zustand der Schutztür 14 zu detektieren, ist an der Schutztür 14 ein Schutztürschalter mit einem Türteil 16 und einem Rahmenteil 18 angebracht. Das Rahmenteil 18 erzeugt auf einer Leitung 20 ein Schutztürsignal, das über die Leitung 20 der neuen Vorrichtung 1 zugeführt ist.

Die Vorrichtung 1 besitzt in diesem Ausführungsbeispiel einen E/A-Teil 24 mit einer Vielzahl von Anschlüssen (bzw. externen oder Geräteanschlüssen) 29. In einigen Ausführungsbeispielen sind die Anschlüsse 29 Anschlussklemmen oder Feldklemmen, die an einer Gehäuseseite des Gehäuses 27 der Vorrichtung 1 angeordnet sind, beispielsweise an einem Anschlussmodulteil, wie im Folgenden erklärt werden wird. Beispielsweise kann es sich um Federzugklemmen oder um Schraubklemmen handeln. In anderen Ausführungsbeispielen können die Anschlüsse Stecker oder Buchsen sein, die mehrere Kontaktelemente (Pins) beinhalten, wobei jeweils ein Pin einen Anschluss bildet. Häufig werden M8-Buchsen mit fünf Kontaktpins für den Anschluss von Meldegeräten oder anderen Sensoren auf Feldebene verwendet. Dementsprechend können Ausführungsbeispiele der neuen Steuerungsvorrichtung Feldgeräte sein oder umfassen, die außerhalb eines Schaltschranks in räumlicher Nähe zu dem Roboter 12 angeordnet sind.

Die Vorrichtung 1 besitzt in diesem Ausführungsbeispiel zwei redundante Signalverarbeitungskanäle. Beispielhaft sind hier zwei Mikrokontroller 28a, 28b dargestellt, die jeweils mit dem E/A-Teil 24 verbunden sind. Die Mikrokontroller 28a, 28b verarbeiten hier redundant zueinander die Eingangssignale, die das Steuerungsvorrichtung 1 an den Geräteanschlüssen des E/A-Teils 24 aufnimmt, und sie vergleichen ihre Ergebnisse, was mit einem Pfeil 29 dargestellt ist. Anstelle von zwei Mikrokontrollern 28a, 28b können Mikroprozessoren, ASICs, FPGAs und/oder andere Signalverarbeitungsschaltkreise verwendet sein. Bevorzugt besitzen Ausführungsbeispiele der Vorrichtung 1 zumindest zwei zueinander redundante Signalverarbeitungskanäle, die jeweils in der Lage sind, logische Signalverknüpfungen vorzunehmen, um in Abhängigkeit davon ein Signal zu erzeugen. Dieses Signal wird dann verwendet, um ein Schaltelement zum Abschalten des Roboters 12 anzusteuern. Eine solche Steuerungsvorrichtung 1 kann dann zum fehlersicheren (FS) Abschalten der Anlage 10, hier des Roboters 12, verwendet werden.

In dem hier dargestellten Fall besitzt die Vorrichtung 1 zwei redundante Schaltelemente 30a, 30b. Jedes dieser beiden Schaltelemente ist in der Lage, ein hohes Spannungspotential 32 zu einem Geräteanschluss 38a, 38b der Vorrichtung 1 durchzuschalten, um einen Stromfluss zu einem Schütz 40a, 40b zu ermöglichen, oder diesen Stromfluss zu unterbrechen. Damit kann jedes der Schaltelemente 30 einen Aktor, wie einen Schütz oder ein Magnetventil, abschalten.

Die Schütze 40a, 40b besitzen jeweils Arbeitskontakte 42a, 42b. Die Arbeitskontakte 42a, 42b sind hier in Reihe zueinander in einen Stromversorgungspfad von einer Stromversorgung 44 zu dem Roboter 12 angeordnet. Sobald die Steuervorrichtung 1 die Schütze 40a, 40b abschaltet, fallen die Kontakte 42 ab und die Stromversorgung für den Roboter 12 wird abgeschaltet. Den einschlägigen Fachleuten ist klar, dass eine solche "radikale" Abschaltung hier beispielhaft beschrieben ist. Abweichend hiervon können bei einer Sicherheitsanforderung lediglich Teile des Roboters 12 abgeschaltet werden, wie etwa die gefährlichen Antriebe, während andere Teile des Roboters 12 funktionsbereit bleiben. Auch ein verzögertes Abschalten ist denkbar, damit der Roboter 12 ggf. vor dem Abschalten der Antriebe kontrolliert abgebremst werden kann.

Die Vorrichtung 1 steuert die Schaltelemente 30a, 30b hier in Abhängigkeit von dem Signal des Schutztürschalters auf der Leitung 20 und in Abhängigkeit von einem weiteren Eingangssignal von einem Not-Aus-Taster 46 an. Auch der Not-Aus-Taster 46 ist über Leitungen mit Geräteanschlüssen der Steuervorrichtung 1 verbunden. Bevorzugt kann jedes der Eingangssignale redundant anliegen bzw. es können jeweils zwei Eingangs- und Ausgangsleitungen oder Anschlüsse vorgesehen sein (in Fig. 1 nicht dargestellt). In dem in Fig. 1 gezeigten Beispiel können also für den Not-Aus-Taster 46 zwei Eingangsleitungen oder Eingänge vorgesehen sein, die jeweils ein Eingangssignal von dem Not-Aus- Taster 46 liefern. Ähnliches gilt für das Signal des Schutztürschalters.

In einigen Ausführungsbeispielen erzeugt die Vorrichtung 1 Ausgangssignale, die den einzelnen Meldegeräten zugeführt sind. Beispielhaft ist ein solches Ausgangssignal über eine Leitung 48 zu dem Rahmenteil 18 des Schutztürschalters geführt. Das Rahmenteil 18 schleift das Ausgangssignal des Sicherheitsschaltgerätes 1 von der Leitung 48 auf die Leitung 19, wenn sich das Türteil 16 in der Nähe des Rahmenteils 18 befindet, das heißt wenn die Schutztür 14 geschlossen ist. Daher kann die Vorrichtung 1 den Schutztürschalter mit Hilfe des Ausgangssignals auf der Leitung 48 und mit Hilfe des Eingangssignals auf der Leitung 19 überwachen. In vergleichbarer Weise überwacht die Steuervorrichtung 1 hier den Not-Aus-Taster 46.

Abweichend von der Darstellung in Fig. 1 werden in der Praxis häufig zwei redundante Ausgangssignale der Vorrichtung 1 verwendet, die jeweils über eine separate Signalleitung zu einem Meldegerät geführt sind und über dieses Meldegerät zurück zur Steuervorrichtung 1 geschleift sind. Beispielhaft für eine solche Realisierung sei auf DE 10 2004 020 995 A1 verwiesen, die hinsichtlich der Details einer solchen redundanten Überwachung eines Meldegerätes durch Bezugnahme aufgenommen ist. Auch der Not-Aus-Taster 46 wird in der Praxis häufig mit redundanten Eingangs- und Ausgangsleitungen überwacht, wie oben erwähnt.

In dem in Fig. 1 dargestellten Ausführungsbeispiel der Vorrichtung 1 wird die Vorrichtung für Sicherheitsaufgaben verwendet, insbesondere zum fehlersicheren (FS) Abschalten einer Anlage. Die Vorrichtung 1 kann jedoch auch für nichtsicherheitsgerichtete Aufgaben bzw. Standardaufgaben (ST) verwendet werden.

Die Vorrichtung 1 ist insbesondere eine modulare Vorrichtung zum Steuern und Regeln, die sich im Wesentlichen aus einer Basis, auch Backplane genannt, und Elektronikmodulen zusammensetzt. Das Backplane dient dabei als Träger der Elektronikmodule und stellt vorzugsweise auch einen Daten- und/oder Versorgungsbus bereit.

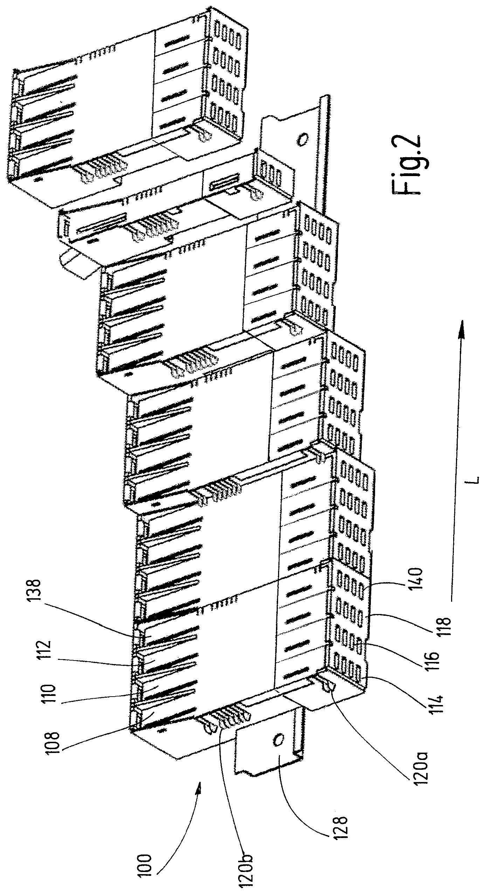

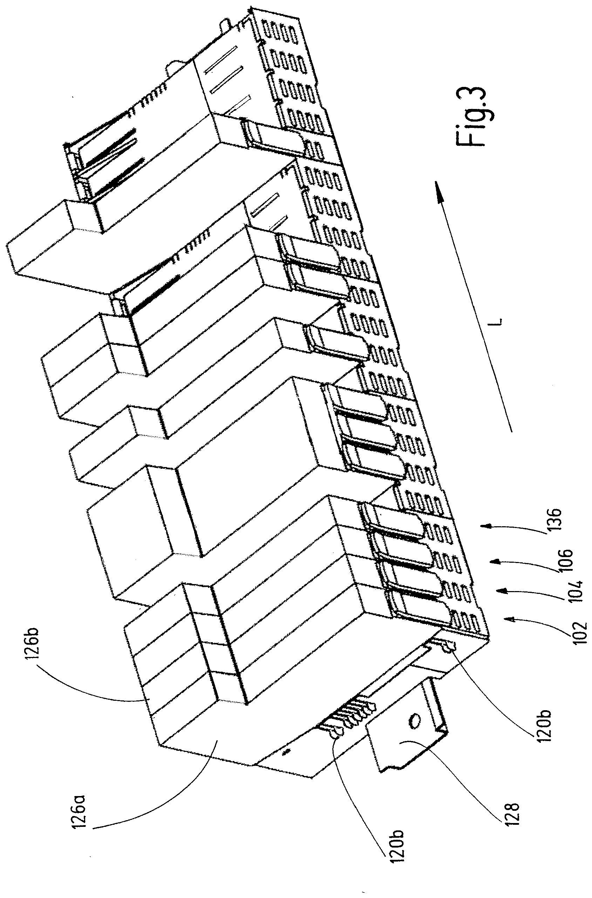

Fig. 2 und 3 zeigen eine perspektivische Darstellung eines Ausführungsbeispiels einer Backplane 100 mit einem ersten, zweiten und dritten Backplanemodul 102, 104, 106, die in einer Längsrichtung L auf einer Tragschiene 128 montiert sind, und mit einer Vielzahl von weiteren Backplanemodulen 136 mit weiteren Grundkörpern 138 und weiteren Kontaktteilen 140, die neben den ersten, zweiten und dritten Backplanemodulen 102, 104, 106 angeordnet sind. Alternativ können das erste, zweite und das dritte Backplanemodul 102, 104, 106 auch an anderer Position innerhalb der Backplane angeordnet werden und/oder entgegen der Längsrichtung L auf der Tragschiene 128 montiert werden. Die ersten, zweiten, dritten und weiteren Backplanemodule 102, 104, 106, 136 sind in diesem Ausführungsbeispiel baugleich, ebenso wie die ersten, zweiten, dritten und weiteren Kontaktteile 114, 116, 118, 140 und die ersten, zweiten, dritten und weitere Grundkörper 108, 110, 112, 138. Im Folgenden wird daher nur von dem Backplanemodul, dem Grundkörper und dem Kontaktteil gesprochen. Einzelne Backplanemodule sind in diesem Ausführungsbeispiel zu integrierten Einheiten zusammengefasst und einstückig gefertigt. Gezeigt sind hier sechs Einheiten, von denen fünf jeweils vier Backplanemodule beinhalten und ein Einheit, welche nur ein einzelnes Backplanemodul beinhaltet.

Die Backplane 100 weist hier ferner einen Kommunikationsbus 120b und einen separaten Versorgungsbus 120a auf. Der Kommunikationsbus 120b verläuft in Längsrichtung L getrennt vom Versorgungsbus 120b durch die Grundkörper der Backplanemodule. Der Versorgungsbus 120a wird durch die Kontaktteile der Backplanemodule gebildet und verläuft parallel zum Kommunikationsbus 120b.

Weiterhin weist jedes Backplanemodul hier eine erste und eine zweite Einstecköffnung 122a, 122b auf, über die Elektronikmodule (nur in Fig. 3 dargestellt) mit den Backplanemodulen und den darin verlaufenden Busleitungen 120a, 120b elektrisch verbunden werden können. Über die erste Einstecköffnung 122a wird in diesem Ausführungsbeispiel eine elektrische Verbindung zu dem Kontaktteil eines Backplanemoduls und dem darin verlaufenden Versorgungsbus 120a hergestellt. In noch näher zu erläuternder Weise kann dabei ein Elektronikmodul entweder eine Versorgungsspannung entnehmen oder einspeisen. Die zweite Einstecköffnung 122b dient der Verbindung eines Elektronikmoduls mit dem Kommunikationsbus 120b, der durch die Grundkörper verläuft.

Die Fig. 3 zeigt die Backplane 100 mit aufgesetzten Elektronikmodulen 126. Ein Elektronikmodul 126 kann bspw. ein Ein-/Ausgabe-Modul, im Folgenden als E/A-Module bezeichnet, sein, welches als ein fehlersicheres Modul (Fail-safe bzw. FS) oder ein nicht-fehlersicheres Standardmodul (ST) ausgelegt seien kann. Beispielhaft für eine solche Realisierung sei auf WO 2005/003869 A1 verwiesen, die hinsichtlich Details einer solchen modularen Steuerungsvorrichtung durch Bezugnahme aufgenommen ist.

Eine fortlaufende Aneinanderreihung von Elektronikmodulen 126 auf der Backplane ist nicht zwingend notwendig. Wie in Fig. 3 zu sehen, muss auf einem bestimmten Backplanemodule nicht zwangsläufig ein Elektronikmodul angeordnet sein, da der Kommunikationsbus 120b und der Versorgungsbus 120a in den Backplanemodulen verlaufen. Daher ist es dem Endnutzer überlassen, wie er die Elektronikmodule auf der Backplane 100 anordnet und zu Gruppen zusammenfügt. Ebenfalls kann sich ein einzelnes Elektronikmodul auch über mehrere Backplanemodule erstrecken, wie in Fig. 3 gezeigt. Durch diesen modularen Aufbau der Vorrichtung sind Änderungen und Anpassungen ohne größeren Aufwand möglich.

Die Vorrichtung 1 kann weiterhin ein Kopfmodul (in Fig. 2 und Fig. 3 nicht dargestellt) aufweisen, das Schnittstellen und einen Verarbeitungsteil umfasst, insbesondere zur Koordination des Datenverkehrs auf dem Kommunikationsbus 120b wie zuvor beschrieben. Das Kopfmodul kann dann ebenfalls auf der Tragschiene 128 montiert sein bzw. werden. In der Fig. 3 kann das Kopfmodul beispielsweise links neben dem in Längsrichtung L ersten Elektronikmodul angeordnet sein und über die Busleitungen 120 mit den Elektronikmodulen verbunden sein.

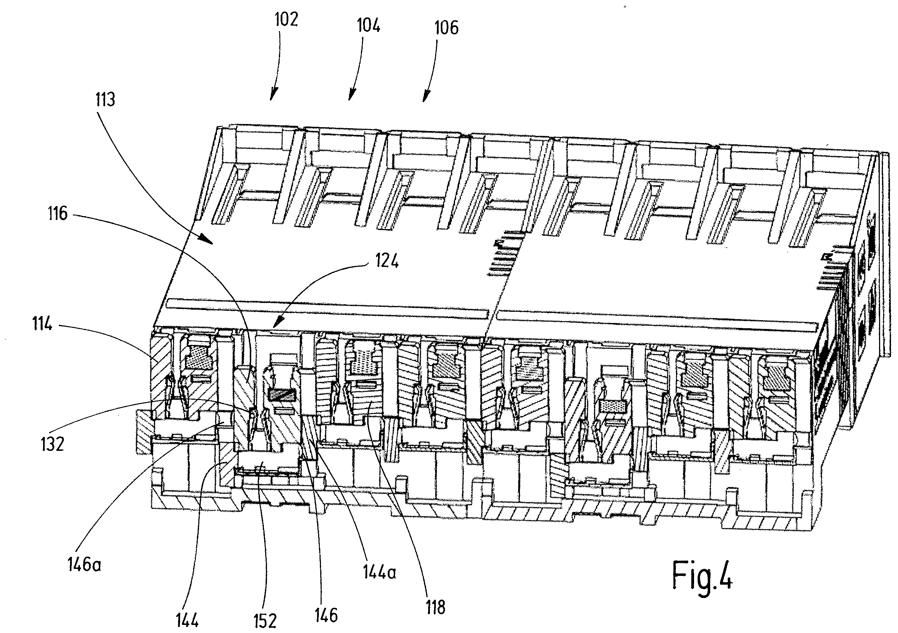

Fig. 4 zeigt eine perspektivische Darstellung von acht Backplanemodulen, wobei auch hier erste, zweite, dritte und weitere Backplanemodule 102, 104, 106, 136 gleich aufgebaut sind. Die Backplanemodule sind zu zwei integrierten Einheiten mit je vier Backplanemodulen zusammengefasst. Das erste Backplanemodul 102 weist ein erstes Kontaktteil 114 in der ersten Variante, das zweite Backplanemodule 104 ein zweites Kontaktteil 116 in einer zweiten Variante und das dritte Backplanemodul 106 ein drittes Kontaktteil wieder in der ersten Variante auf.

Die Kontaktteile 114, 116, 118 sind hier jeweils in einer Vertiefung 124 der Grundkörper beweglich angeordnet und können in eine von zwei Positionen verstellt werden. In der ersten Position schließt die Oberseite des Kontaktteils jeweils bündig mit der Oberseite 113 des Grundkörpers ab, während in der zweiten Position das Kontaktteil in den Grundkörper nach unten eingedrückt ist. Vorzugsweise sind die Kontaktteile in beiden Fällen jeweils innerhalb der Ausmaße bzw. innerhalb der Einhüllenden des Grundkörpers angeordnet und sie ragen nicht darüber hinaus. Über ein verstellbares Element 130 kann ein Kontaktteil in der jeweiligen Position fixiert werden. In diesem Ausführungsbeispiel ist dazu ein Stift am Kontaktteil angeordnet, der in der jeweiligen Position in eine Aufnahme am Grundkörper geschoben und befestigt werden kann und so das Kontaktteil vor einem versehentlichen Verstellen schützt. Ein Kontaktteil ist in der ersten Variante, wenn es sich in der ersten Position befindet, und in der zweiten Variante, wenn es sich in der zweiten Position befindet.

Zur Verdeutlichung der Verkettung der Backplanemodule miteinander ist in der Fig. 4 weiterhin ein Querschnitt durch die Kontaktteile der Backplanemodule gezeigt. Die Kontaktteile bilden einzelne Abschnitte eines Versorgungsbusses 120 der entlang der Längsrichtung L verläuft. Das zweite Kontaktteil 116 und in diesem Beispiel auch alle anderen Kontaktteile weisen hierzu je einen metallischen Leiter 152 auf, der durch das Kontaktteil 116 in Längsrichtung L verläuft und an den Enden Kontakte zum Verbinden mit den benachbarten Kontaktteilen 114, 118 aufweist. Auf der einen Seite sind hier als Kontakte flache metallische Kontaktmesser 144, die aus dem Kontaktteil hinausragen, angeordnet und auf der gegenüberliegenden Seite sind hier passende Gegenkontakte 146 ausgebildet, hier in Form von tulpenförmigen Aufnahmen, in die die Kontaktmesser benachbarter Kontaktteile eingreifen können. Nebeneinanderliegenden Kontaktteile bilden über die metallischen Leiter eine Kette, durch die der Bus verläuft.

Das zweite Kontaktteil 116 des zweiten Backplanemoduls 104 befindet sich hier dargestellt in der zweiten Variante, d.h. der Versorgungsbus wird an dieser Stelle aufgetrennt. Das zweite Kontaktteil 116 ist dabei tieferliegend angeordnet als das erste oder dritte Kontaktteil 114, 118, so dass auch der metallische Leiter 152 tiefer liegt. Der Gegenkontakt 146a am ersten Kontaktteil 114 ist hier so ausgebildet, dass er mit dem tieferliegenden Kontaktmesser 144 keine elektrische Verbindung eingeht, auf der gegenüberliegenden Seite jedoch eine elektrische Verbindung zwischen dem tieferliegenden Leiter 152 und dem Kontaktmesser 144a des dritten Kontaktteils bestehen bleibt. Dies wird hier dadurch erreicht, dass die Kontaktmesser 144 in Schieberichtung der Kontakteile und somit quer zur Längsrichtung L länger ausgebildet sind als die Gegenkontakte 146. Außerdem sind die Gegenkontakte 146 asymmetrisch bzw. einseitig nach oben versetzt an den Leitern 152 angeordnet. Wie man in Fig. 4 anhand des ersten, zweiten und dritten Kontaktteils 114, 116, 118 erkennen kann, reicht der Messerkontakt 144 des zweiten Kontaktteils 116 nicht an den höher liegenden Gegenkontakt 146a des ersten Kontaktteils 114 heran, während der Gegenkontakt 146 des zweiten Kontaktteils trotz der nach unten verschobenen Position das untere freie Ende des Kontakts 144a des dritten Kontaktteils 118 berührt. Prinzipiell könnten die Dimensionen der Kontakte 144 und Gegenkontakte 146 auch umgekehrt sein. Des Weiteren könnten die Kontaktteile nicht nur von oben nach unten heruntergedrückt werden, um den Versorgungsbus zu unterbrechen. Prinzipiell ist auch ein Hochziehen und/oder Verdrehen denkbar. Das hier dargestellte Ausführungsbeispiel ist jedoch von Vorteil, weil die Busleitung hier im Auslieferungszustand der Backplanemodule geschlossen ist und durch einfaches Herunterdrücken der ausgewählten Kontaktteile unterbrochen werden kann.

Der Versorgungsbus 120 wird hier zwischen dem ersten und zweiten Kontaktteil 116 getrennt und ein neuer Busabschnitt des Versorgungsbusses wird mit dem zweiten Kontaktteil 116 und dessen elektrischer Verbindung zum dritten Kontaktteil 118 begonnen. Befindet sich das zweite Kontaktteil 116 in der ersten Variante (oben), liegt der metallische Leiter 152 auf einer Höhe mit den metallischen Leitern in den benachbarten Kontaktteilen und es besteht eine elektrische Verbindung zu beiden Seiten.

Der metallische Leiter 152 ist zusätzlich mit einem Versorgungsanschluss 132, hier in Form einer U-förmigen, nach oben geöffneten Federklemme, verbunden, der unterhalb der Einstecköffnung 122a angerordnet ist. Beim Aufsetzen eines Elektronikmoduls auf die Backplane wird ein Kontakt des Elektronikmoduls durch die Einstecköffnung 122a zum Kontaktteil geführt, der sich je nach Aufbau des Elektronikmoduls mit dem Versorgungsanschluss 132 verbindet oder nicht.

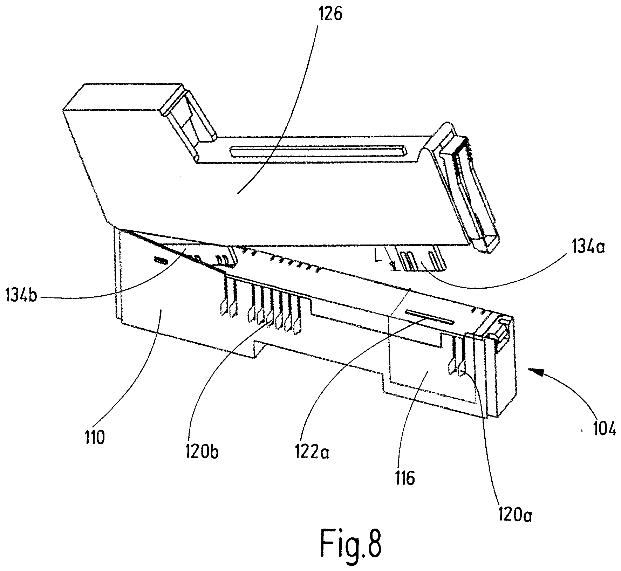

In diesem Ausführungsbeispiel weist ein Elektronikmodul (hier nicht dargestellt), welches eine Spannung aus dem Bus beziehen soll, einen vergleichsweise kurzen Kontakt 134 auf (vgl. Fig. 8), der den Versorgungsanschluss 132 nur kontaktieren kann, wenn sich das entsprechende Kontaktteil in der ersten Variante befindet. Ist das entsprechende Kontaktteil in der zweiten Variante, liegt der Versorgungsanschluss 132 zu tief und es kommt keine Verbindung zwischen dem Kontakt des eingesteckten Elektronikmoduls und dem Versorgungsanschluss zustande. Der metallische Leiter und der damit verbundene Versorgungsanschluss liegen so tief, dass sie vom Kontakt des Elektronikmoduls nicht erreicht werden können. Ein Einspeisemodul hingegen hat in diesem Ausführungsbeispiel einen längeren Kontakt134 im Vergleich zu dem Elektronikmodul und kann folglich auch den tiefer liegenden Versorgungsanschluss 132 erreichen und kontaktieren. Ein zusätzlicher Vorteil diese Aufbaus ist, dass beim Versuch ein Einspeisemodul auf einen Kontaktteil in der ersten Variante aufzusetzen, dieser automatisch in die zweite Variante versetzt werden kann, indem der Kontaktanschluss des Einspeisemoduls den Versorgungsanschluss eindrückt und somit den gesamten Kontaktteil einrückt und in die zweite Variante überführt. Dies setzt im vorliegenden Ausführungsbeispiel allerdings voraus, dass das Verriegelungselement zum Fixieren des Kontaktteils gelöst ist oder ein solches Verriegelungselement gar nicht vorhanden ist.

Aus der Querschnittsansicht ist weiterhin ersichtlich, dass, wenn die Kontaktteile gleich aufgebaut sind, an jedem Backplanemodul der Bus aufgetrennt und ein neuer Busabschnitt begonnen werden kann. Dazu sind alle Kontaktteile so variabe aufgebaut wie das zweite Kontaktteil 116. Das jeweils vorherige Kontaktteil in der Reihe verhält sich wie ein erstes Kontaktteil und das folgende Kontaktteil wie ein drittes Kontaktteil bezogen auf ein beliebiges Kontaktteil der Reihe. Auf diese Weise kann der Versorgungsbus 120 in einzelne separate Busabschnitte aufgeteilt werden. Die Busabschnitte können durch Einspeisen unterschiedlicher Versorgungsspannungen verschiedene Potentialgruppen bilden.

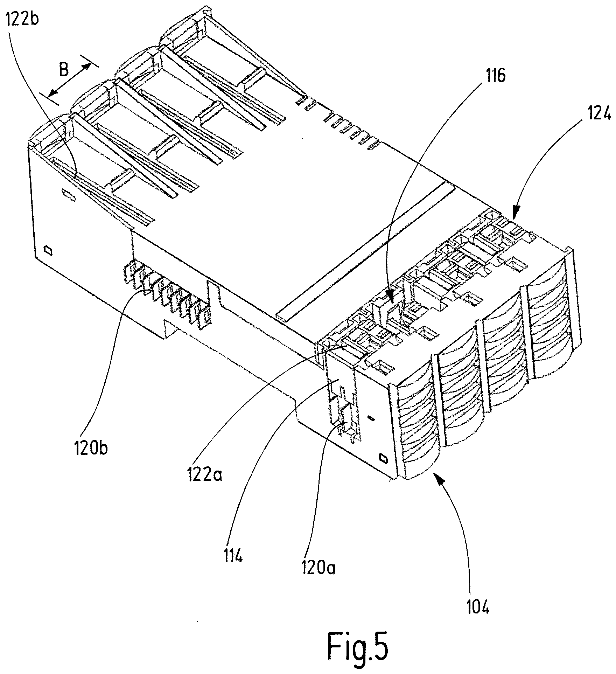

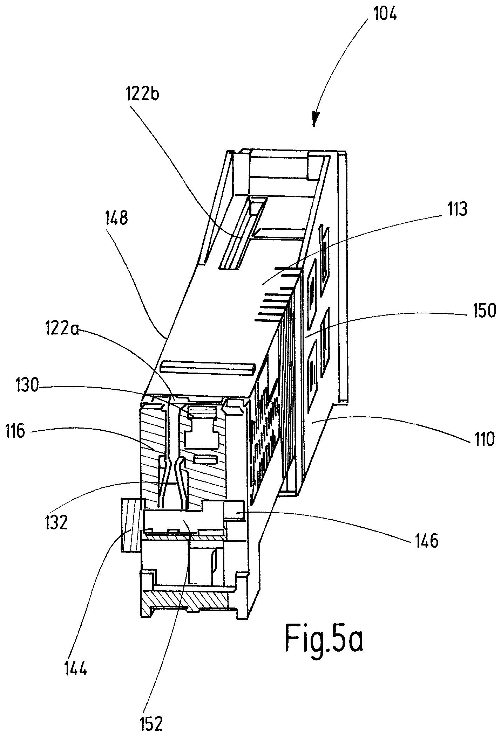

Die Fig. 5 und Fig. 5a zeigen zwei verschiedene bevorzugte Bauformen für Backplanemodule. Die Fig. 5 zeigt eine perspektivische Darstellung eines Ausführungsbeispiels einer Bauform mit vier zu einem "Stück" zusammengefassten Backplanemodulen. Die vier Grundkörper des Backplanemoduls sind hier einstückig gefertigt und bilden eine untrennbare Einheit, während die Kontaktteile 116 der Backplanemodule 104 weiterhin einzelne Modulelemente sind, die an den Grundkörpern, vorzugsweise verliersicher, angeordnet sind. Die Fertigung der Kontaktteile als separate Modulelemente verdeutlicht dabei den modularen Aufbau des Versorgungsbusses 120a gegenüber dem parallel verlaufenden Kommunikationsbus 120b. Während der Kommunikationsbus 120b in gleicher Weise durch alle Backplanemodule durchgeschleift wird und daher fest in den Grundkörper bzw. die Kombination der Grundkörper integriert ist, ist der Versorgungsbus 120a an jedem Backplanemodul über die Kontaktteile individuell einstellbar.

Fig. 5a zeigt ein weiteres Ausführungsbeispiel eines Backplanemoduls 104. Diese Ausgestaltung bietet höchste Flexibilität, ist jedoch aufwändiger beim Aufbau größer Blackplanes. Vorzugsweise werden daher beide in Fig. 5 und Fig. 5a gezeigten Bauformen in Kombination eingesetzt und die neue Vorrichtung beinhaltet dementsprechend Backplanemodule in beiden Bauformen.

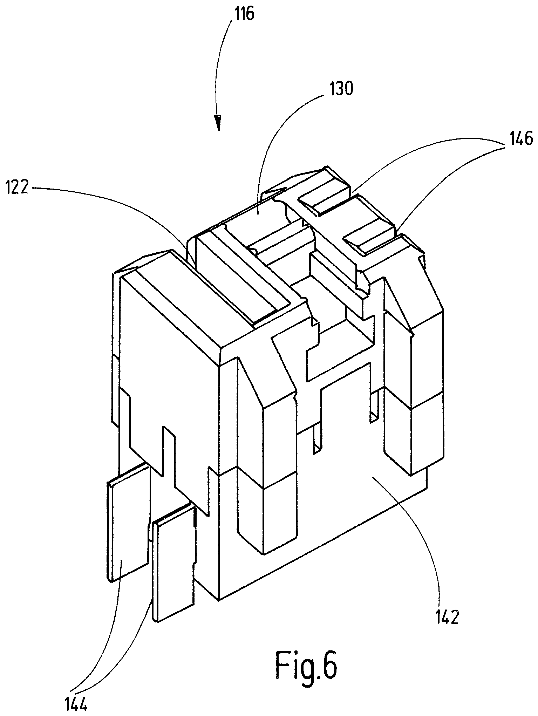

Fig. 6 zeigt eine perspektivische Darstellung eines Ausführungsbeispiels eines zweiten Kontaktteils 116. Der zweite Kontaktteil 116 weist hier einen eigenen Kunststoffkörper 142 auf mit daraus hervorstehenden Kontaktmessern 144 auf der einen Seite und entsprechende Gegenkontakten 146 auf der gegenüberliegenden (abgewandten) Seite. Die Gegenkontakte 146 sind hier tulpenförmige Aufnahmen, in die die Kontaktmesser eines benachbarten Kontaktteils senkrecht von oben eingreifen können. Dargestellt sind hier je zwei Kontakte je Seite für einen zweiadrigen Bus. Alternative könnt der Versorgungsbus auch weitere Adern oder nur eine einzige Ader aufweisen.

Ein Gegenkontakt 146 ist mit jeweils einem Kontaktmesser 144 innerhalb des Kontaktteils 116 durch einen elektrischen Leiter verbunden. Vorzugsweise sind der Leiter und die jeweiligen Kontakte ein einziges metallisches Bauteil, welches in Spritzgusstechnik umspritzt wird, um einen robusten Kunststoffkörper 142 für das Kontaktteil 116 herzustellen. Weiterhin verfügt das Kontaktteil 116 über eine Einstecköffnung 122, in die elektrische Kontakte 134 eines Elektronikmoduls eingesteckt werden können. Hinter der Einstecköffnung verbirgt sich hier die U-förmige Klemme 132, die mit den elektrischen Leiter innerhalb des Kontaktteils 116 verbunden ist und mit dem eingesteckten Kontakt eines Elektronikmoduls eine elektrische Verbindung herstellt.

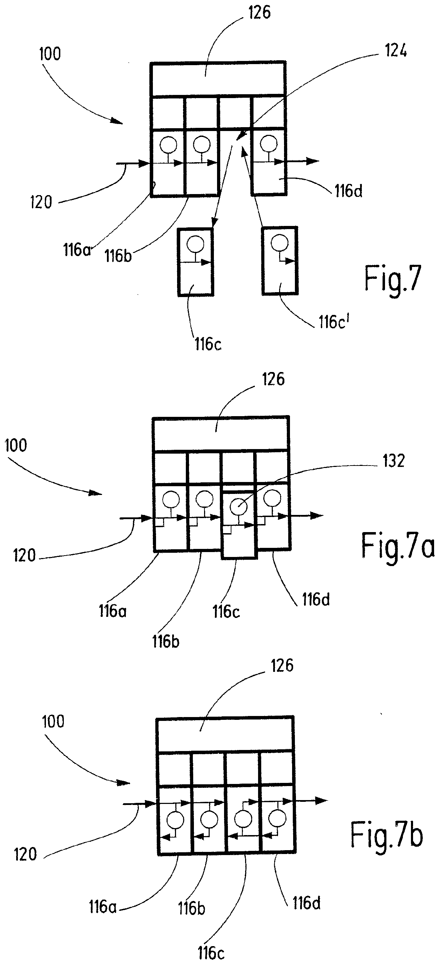

Die Fig. 7, 7a und 7b zeigen schematisch verschiedene weitere Ausführungsbeispiele der neuen Vorrichtung. In allen drei Figuren ist eine Vorrichtung mit einem Elektronikmodul 126, welches auf einer Backplane aufgesetzt ist, gezeigt. Das Elektronikmodul 126 erstreckt sich hier über vier Backplanemodule. Die Backplane 100 setzt sich aus vier einzelnen Backplanemodulen zusammen, die in diesem Beispiel alle gleichförmige Grundkörper aufweisen. An den Grundkörpern sind vier zweite Kontaktteile 116a, 116b, 116c, 116d angeordnet, durch die eine Versorgungsbusleitung 120 (dargestellt durch die Pfeile) verläuft. In Längsrichtung L betrachtet sind die zweiten Kontaktteile 116a, 116b, 116d in erster, zweiter und vierter Position in der ersten Variante und das zweite Kontaktteil 116c in der dritten Position ist in der zweiten Variante.

In Fig. 7 ist das zweite Kontaktteil 116c lös- und austauschbar am Grundkörper befestigt. Wahlweise kann an ein Kontaktteil 116c oder ein Kontaktteil 116c' an der Aufnahme 124 befestigt werden. Das Kontaktteil 116c bildet die erste Variante. Das Kontaktteil 116c' bildet die alternative zweite Variante. Die beiden Varianten werden hier durch zwei verschiedene Ausführungsformen des zweiten Kontaktteils 116c, 116c' realisiert.

In Fig. 7a ist das zweite Kontaktteil 116c (an der dritten Position) versetzt zu den anderen Kontaktteilen 116a, 116b, 116d angeordnet. Das Kontaktteil 116c nimmt eine andere Position ein als die benachbarten Kontaktteile 116a, 116b und 116d. Es besteht dabei eine elektrische Verbindung zum nachfolgenden (hier rechtsliegenden) Kontaktteil 116d, jedoch keine Verbindung zum vorherigen (hier links liegenden) Kontaktteil 116b. Weiterhin ist in diesem Ausführungsbeispiel der Versorgungsanschluss 132 bezogen auf den Grundkörper versetzt, wodurch die Kontakttierbarkeit eines aufgesetzten Elektronikmoduls beeinflusst wird. Vorzugsweise ist es dabei nur Einspeisemodulen mechanisch möglich, den Versorgungsanschluss 132 des versetzten Kontaktteil 116c zu kontaktieren. Ein Verschieben des Kontaktteils 116c in eine den Kontaktteilen 116a, 116b, 116d entsprechende Position führt dazu, dass die Busleitung durch alle vier hier gezeigten Kontaktteile durchgeschleift ist. Die beiden Varianten sind hier also anhand der Position des Kontaktteils 116c relativ zu den anderen Kontaktteilen 116a, 116b, 116d auswählbar. Dies entspricht der Variabilität des Ausführungsbeispiels aus den Fig. 2 bis 6.

In Fig. 7b ist das zweite Kontaktteil 116c wiederum in der zweiten Variante dargestellt. Zum Ändern der Variante wurde das zweite Kontaktteil 116c in diesem Ausführungsbeispiel nicht ersetzt oder in eine an der Position bezogen auf den Grundkörper gebracht, sondern die Orientierung des Kontaktteils um 180° Grad gedreht. Durch die andere Orientierung ist der Kontaktteil 116c in der zweiten Variante, jedoch in gleicher Position im Bezug zum Grundkörper. In dieser Ausführung ist der Versorgungsanschluss 132 bezogen auf den Grundkörper vorzugsweise in jeweils gleicher Position.

Fig. 8 zeigt ein weiteres Ausführungsbeispiel mit einem einzelnen Backplanemodule 104, auf welches ein separates Elektronikmodul 126 aufgesetzt wird. Das Elektronikmodul 126 ist dabei erst zur Hälfte auf das Backplanemodul 104 aufgesetzt, indem ein erstes Ende des Elektronikmoduls 126 an einer passenden Aufnahme des Backplanemoduls 110 eingehakt wurde. Das Elektronikmodul wird dann mit einer Schwenkbewegung um das erste Ende gegen die Oberfläche 113 des Backplanemoduls gedrückt. Das Backplanemodul 104 weist auch hier einen Kommunikationsbus 120b, der durch den Grundkörper 110 verläuft, und einen Versorgungsbus 120a, welcher durch das zweite Kontaktteil 116 verläuft, auf. Das Elektronikmodul 126 kontaktiert das Backplanemodul in diesem Ausführungsbeispiel über zwei Kontaktgruppen 134a, 134b. Die Kontaktgruppe 134b (hier in der bevorzugten Form einer aus dem Gehäuse des Elektronikmoduls herausragenden Leiterplatte, auf der Kontaktbahnen ausgebildet sind) wird mit der Schwenkbewegung in die zweite Einstecköffnung 122b gesteckt und stellte eine elektrische Verbindung zum Kommunikationsbus 120b her, während die erste Kontaktgruppe 134a in eine erste Einstecköffnung 122a am Kontaktteil 116 greift und eine elektrische Verbindung zum Versorgungsbus 120a herstellt, und zwar in Abhängigkeit davon, ob das Kontaktteil 116 in der ersten oder zweiten Variante ist.

Ob ein Elektronikmodul 126 eine elektrische Verbindung zum zweiten Kontaktteil 116 in einer der beiden Varianten herstellen kann, ist in diesem Ausführungsbeispiel durch die Ausprägung der ersten Kontaktgruppe 134a, insbesondere durch deren Länge I, bestimmt. Vorzugsweise ist bei einem Einspeisemodul, welches das Kontaktteil bevorzugt in der zweiten Variante kontaktieren muss, die erste Kontaktgruppe 134a länger als bei einem Elektronikmodul, das nur über ein Kontaktteil in der ersten Variante eine Verbindung herstellen soll. Durch diese Konstruktion kann ein Einspeisemodul auch nicht versehentlich auf ein Kontaktteil in der ersten Variante aufgesetzt werden, da sich der erste Kontakt 136 dafür als für zu lang erweist. Auf diese Weise wird mechanisch vermieden, dass ein falsches Modul auf ein Kontaktteil aufgesteckt wird.

Alternativ können auch andere Konstruktionen, beispielsweise durch unterschiedliche Form der Versorgungsanschlüsse 132 des zweiten Kontaktteils in den beiden Varianten, genutzt werden, um ein fehlersicheres Aufstecken von Elektronikmodulen zu realisieren.

Insgesamt kann eine Backplane durch die erfindungsgemäße Vorrichtung eine separate Busstruktur aufweisen, die sich einfach und flexibel konfigurieren und den jeweiligen Bedürfnissen anpassen lässt. Die variablen Kontaktteile können separat von den Grundkörpern der Backplane hergestellt und auf die Anforderungen des Busses optimiert werden.

## Patentansprüche

1. Vorrichtung zum Steuern und/oder Regeln einer technischen Anlage (10), mit einem ersten Backplanemodul (102), einem zweiten Backplanemodul (104) und zumindest einem dritten Backplanemodul (106), die nebeneinander auf einer Tragschiene (128), welche eine Längsrichtung (L) definiert, positionierbar sind, wobei das erste Backplanemodul (102) einen ersten Grundkörper (108) und ein erstes Kontaktteil (114) besitzt, wobei das zweite Backplanemodul (104) einen zweiten Grundkörper (110) und ein zweites Kontaktteil (116) besitzt, und wobei das dritte Backplanemodul (106) einen dritten Grundkörper (112) und ein drittes Kontaktteil (118) besitzt, wobei die Grundkörper (108, 110, 112) jeweils eine Oberseite (113) mit Einstecköffnungen (122) haben, in die elektrische Kontakte (134) von separaten Elektronikmodulen (126) einsteckbar sind, und wobei die Kontaktteile (114, 116, 118) eine Busleitung (120) in der Längsrichtung (L) bilden, über die eingesteckte Elektronikmodule (126) elektrisch miteinander koppelbar sind, wobei der zweite Grundkörper (110) eine Aufnahme (124) aufweist, an der das zweite Kontaktteil (116) wahlweise in einer von zumindest zwei definierten Varianten angeordnet ist, wobei das zweite Kontaktteil (116) in einer ersten Variante von den zumindest zwei Varianten eine elektrisch leitfähige Verbindung zum ersten Kontaktteil (114) und zum dritten Kontaktteil (118) besitzt, und wobei das zweite Kontaktteil (116) in einer zweiten Variante von den zumindest zwei Varianten eine elektrisch leitfähige Verbindung zu dem dritten Kontaktteil (118) besitzt, nicht jedoch zu dem ersten Kontaktteil (114), wobei das zweite Kontaktteil (116) eine definierte erste Pose und zumindest eine alternative zweite Pose an der Aufnahme (124) einnehmen kann, wobei die erste Pose die erste Variante bildet und wobei die alternative zweite Pose die zweite Variante bildet, sodass das zweite Kontaktteil (116) je nach Variante an einer von zumindest zwei Positionen und/oder in zumindest zwei verschiedenen Orientierungen angeordnet sein kann, **dadurch gekennzeichnet, dass** das zweite Kontaktteil (116) einen Kunststoffkörper (142) aufweist, in dem ein erster Metallkontakt (144) und ein zweiter Metallkontakt (146) zur elektrischen Verbindung mit dem ersten und dritten Kontaktteil (114, 118) eingelassen sind, und wobei der zweite Metallkontakt (146) auf einer dem ersten Metallkontakt (144) abgewandten Seite des Kunststoffkörpers (142) angeordnet ist.

2. Vorrichtung nach Anspruch 1, **dadurch gekennzeichnet, dass** der erste und der dritte Grundkörper (108, 112) jeweils eine weitere Aufnahme aufweisen, wobei das erste Kontaktteil (114) und das dritte Kontaktteil (118) in jeweils einer der weiteren Aufnahmen angeordnet sind.

3. Vorrichtung nach Anspruch 1 oder 2, **gekennzeichnet durch** ein weiteres Backplanemodul (136) mit einem weiteren Grundkörper (138) und einem weiteren Kontaktteil (140), wobei das dritte Kontaktteil (118) in Bezug auf das zweite Kontaktteil (116) und das weitere Kontaktteil (140) in gleicher Weise variabel ist, wie das zweite Kontaktteil (116) in Bezug auf das erste Kontaktteil (114) und das dritte Kontaktteil (118).

4. Vorrichtung nach einem der Ansprüche 1 bis 3, **gekennzeichnet durch** ein Verriegelungselement (130) mit dem das zweite Kontaktteil (116) an der Aufnahme wahlweise in der ersten Pose oder in der zweiten Pose fixiert werden kann.

5. Vorrichtung nach einem der Ansprüche 1 bis 4, **dadurch gekennzeichnet, dass** die erste Pose eine erste räumliche Position des zweiten Kontaktteils (116) an der Aufnahme (124) ist, und dass die zweite Pose eine zweite räumliche Position ist, in die das zweite Kontaktteil (116) mit einer Translationsbewegung verschiebbar ist.

6. Vorrichtung nach einem der Ansprüche 1 bis 5, **dadurch gekennzeichnet, dass** die Busleitung (120) eine Anzahl von ersten Adern (120b) und eine Anzahl von separaten zweiten Adern (120a) aufweist, wobei die ersten Adern (120b) einen Datenbus zum Übertragen von Steuerdaten bilden, und wobei die zweiten Adern (120a) eine Stromschiene zum Verteilen einer Versorgungsspannung bilden, wobei die zweiten Adern (120a) durch die Kontakteile (114, 116, 118) laufen, während die ersten Adern (120b) entfernt von den Kontaktteilen (114, 116, 118) in den Grundkörpern (108, 110, 112) angeordnet sind.

7. Vorrichtung nach einem der Ansprüche 1 bis 6, **dadurch gekennzeichnet, dass** zumindest das zweite Kontaktteil (110) zerstörungsfrei herausnehmbar an der Aufnahme (124) angeordnet ist.

8. Vorrichtung nach einem der Ansprüche 1 bis 7, **dadurch gekennzeichnet, dass** der zweite Grundkörper (110) eine definierte Breite (B) in Längsrichtung besitzt, wobei sich das zweite Kontaktteil (116) im Wesentlichen über die definierte Breite erstreckt.

9. Vorrichtung nach einem der Ansprüche 1 bis 8, **dadurch gekennzeichnet, dass** zumindest zwei der Grundkörper (108, 110, 112) eine integrierte bauliche Einheit bilden.

10. Vorrichtung nach einem der Ansprüche 1 bis 9, **dadurch gekennzeichnet, dass** das zweite Kontaktteil (116) einen Kunststoffkörper (142) aufweist, der vollständig innerhalb der Aufnahme (124) angeordnet ist.

11. Vorrichtung nach einem der Ansprüche 1 bis 10, **gekennzeichnet durch** ein erstes und zumindest ein zweites Elektronikmodul (126a, 126b), die wahlweise auf die Grundkörper (108, 110, 112) aufsteckbar sind, wobei das erste Elektronikmodul (126a) erste elektrische Kontakte (134a) und das zweite Elektronikmodul (126b) zweite elektrische Kontakte aufweist, wobei die ersten elektrischen Kontakte (134a) so ausgebildet sind, dass sie das zweite Kontaktteil (110) im aufgesteckten Zustand nur in der ersten Variante elektrisch kontaktieren können, während die zweiten elektrischen Kontakte so ausgebildet sind, dass sie das zweite Kontaktteil (110) im aufgesteckten Zustand nur in der zweiten Variante elektrisch kontaktieren können.

12. Backplanemodul zur Verwendung in einer Vorrichtung nach einem der Ansprüche 1 bis 11, mit einem Grundkörper, der eine Oberseite (113) und zumindest eine erste und eine zweite Seitenfläche (148, 150) aufweist, wobei die Oberseite (113) Einstecköffnungen (122) aufweist, die zur mechanischen Befestigung und elektrischen Kontaktierung eines separaten Elektronikmoduls (126) ausgebildet sind, wobei die erste Seitenfläche (148) zur mechanischen Verbindung mit einem typgleichen ersten Backplanemodul (102) ausgebildet ist, und wobei die zweite Seitenfläche (150) zur mechanischen Verbindung mit einem typgleichen zweiten Backplanemodul (106) ausgebildet ist, ferner mit zumindest einem Kontaktteil (116), das mindestens einen elektrischen Kontakt (146) aufweist, der zum elektrischen Anschluss des typgleichen ersten oder zweiten Backplanemoduls ausgebildet ist, und mit einer Aufnahme (124), an der das Kontaktteil wahlweise in einer von zumindest zwei definierten Varianten positionierbar ist, wobei das Kontaktteil (116) in einer ersten Variante von den zumindest zwei Varianten mit einem ersten typgleichen mit der ersten Seitenfläche mechanisch verbindbaren Backplanemodul (102) und mit einem zweiten typgleichen mit der zweiten Seitenfläche verbindbaren Backplanemodul (106) elektrisch leitfähig verbindbar ist, und wobei das Kontaktteil (116) in einer zweiten Variante von den zumindest zwei Varianten mit dem zweiten typgleichen mit der zweiten Seitenfläche verbindbaren Backplanemodul (106) elektrisch verbindbar ist, jedoch nicht mit dem ersten mit der ersten Seitenfläche mechanisch verbindbaren typgleichen Backplanemodul (102), **gekennzeichnet dadurch, dass** das Kontaktteil (116) eine definierte erste Pose und zumindest eine alternative zweite Pose an der Aufnahme (124) einnehmen kann, wobei die erste Pose die erste Variante bildet und wobei die zweite Pose die zweite Variante bildet, sodass das Kontaktteil (116) je nach Variante an einer von zumindest zwei Positionen und/oder in zumindest zwei verschiedenen Orientierungen angeordnet sein kann, **dadurch gekennzeichnet, dass** das zweite Kontaktteil (116) einen Kunststoffkörper (142) aufweist, in dem ein erster Metallkontakt (144) und ein zweiter Metallkontakt (146) zur elektrischen Verbindung mit dem ersten und dritten Kontaktteil (114, 118) eingelassen sind, und wobei der zweite Metallkontakt (146) auf einer dem ersten Metallkontakt (144) abgewandten Seite des Kunststoffkörpers (142) angeordnet ist.

## Claims

1. A device for open-loop control and/or closed-loop control of a technical installation (10), comprising a first backplane module (102), a second backplane module (104) and at least a third backplane module (106) configured to be positioned adjacent to one another on a mounting rail (128) that defines a longitudinal direction (L), wherein the first backplane module (102) comprises a first main body (108) and a first contact part (114), wherein the second backplane module (104) comprises a second main body (110) and a second contact part (116) and wherein the third backplane module (106) comprises a third main body (112) and a third contact part (118), wherein the main bodies (108, 110, 112) each have an upper side (113) comprising insertion openings (122) configured to receive electrical contacts (134) of separate electronic modules (126), and wherein the contact parts (114, 116, 118) form a bus line (120) in the longitudinal direction (L) by means of which plugged-in electronic modules (126) can be electrically coupled to one another, wherein the second main body (110) comprises a receptacle (124) and the second contact part (116) is selectively arranged in said receptacle in one of at least two defined variants, wherein the second contact part (116) has an electrically conductive connection to the first contact part (114) and to the third contact part (118) in a first variant of the at least two variants, and wherein the second contact part (116), in a second variant of the at least two variants, has an electrically conductive connection to the third contact part (118) but not to the first contact part (114), wherein the second contact part (116) can assume a defined first positional arrangement and at least one alternative second positional arrangement in the receptacle (124), wherein the first positional arrangement forms the first variant and wherein the alternative second positional arrangement forms the second variant such that the second contact part (116) can be arranged, depending on the variant, in one of at least two different positions and/or in one of at least two different alignments on the main body, **characterized in that** the second contact part (116) comprises a synthetic material body (142) having embedded a first metal contact (144) and a second metal contact (146) for an electrical connection to the first and third contact parts (114, 118), and wherein the second metal contact (146) is arranged on a side of the synthetic material body (142), said side facing away from the first metal contact (144).

2. The device of claim 1, **characterized in that** the first and the third main body (108, 112) each comprise a further receptacle, wherein the first contact part (114) and the third contact part (118) are arranged in a respective one of the further receptacles.

3. The device of claim 1 or 2, **characterized by** a further backplane module (136) having a further main body (138) and a further contact part (140), wherein the third contact part (118) can be varied with respect to the second contact part (116) and the further contact part (140) in the same manner as the second contact part (116) can be varied with respect to the first contact part (114) and the third contact part (118).

4. The device of any one of claims 1 to 3, **characterized by** a locking element (130) by means of which the second contact part (116) can selectively be fixed in the receptacle in the first positional arrangement or in the second positional arrangement.

5. The device of any one of claims 1 to 4, **characterized in that** the first positional arrangement is a first spatial position of the second contact part (116) in the receptacle (124), and that the second positional arrangement is a second spatial position into which the second contact part (116) can be shifted by a translational motion.

6. The device of any one of claims 1 to 5, **characterized in that** the bus line (120) comprises a number of first cores (120b) and a number of separate second cores (120a), wherein the first cores (120b) form a data bus for transmitting control data, and wherein the second cores (120a) form a current rail for distributing a supply voltage, wherein the second cores (120a) extend through the contact parts (114, 116, 118), whereas the first cores (120b) are arranged remote from the contact parts (114, 116, 118) in the main bodies (108, 110, 112).

7. The device of any one of claims 1 to 6, **characterized in that** at least the second contact part (110) is arranged in the receptacle (124) in such a manner that said second contact part can be detached in a non-destructive manner.

8. The device of any one of claims 1 to 7, **characterized in that** the second main body (110) has a defined width (B) in the longitudinal direction, wherein the second contact part (116) extends essentially over the defined width.

9. The device of any one of claims 1 to 8, **characterized in that** at least two of the main bodies (108, 110, 112) form an integrated structural unit.

10. The device of any one of claims 1 to 9, **characterized in that** the second contact part (116) comprises a synthetic material body (142) that is completely arranged in the receptacle (124).

11. The device of any one of claims 1 to 10, **characterized by** a first and at least one second electronic module (126a, 126b) that can selectively be plugged onto the main bodies (108, 110, 112), wherein the first electronic module (126a) has first electrical contacts (134a) and the second electronic module (126b) has second electrical contacts, wherein the first electrical contacts (134a) are designed to make electrical contact with the second contact part (110) in a plugged-on state only in the first variant, whereas the second electrical contacts are designed to make electrical contact with the second contact part (110) in the plugged-on state only in the second variant.

12. A backplane module for use in a device according to any one of claims 1 to 11, said backplane module comprising a main body that has an upper side (113) and at least a first and a second side face (148, 150), wherein the upper side (113) comprises insertion openings (122) designed for mechanical fastening and electrically contacting a separate electronic module (126), wherein the first side face (148) is designed for mechanically connecting to a similar-type first backplane module (102), and wherein the second side face (150) is designed for mechanically connecting to a similar-type second backplane module (106), further comprising at least one contact part (116) that has at least one electrical contact (146) configured for electrically connecting the similar-type first or second backplane module, and comprising a receptacle (124) in which the contact part can selectively be arranged in one of at least two defined variants, wherein the contact part (116) can be connected electrically conductive to a first similar-type backplane module (102), which can mechanically be connected to the first side face, and to a second similar-type backplane module (106), which can be connected to the second side face, in a first variant of the at least two variants, and wherein the contact part (116) can be connected electrically conductive to the second similar-type backplane module (106), which can be connected to the second side face, but not to the first similar-type backplane module (102), which can mechanically be connected to the first side face, in a second variant of the at least two variants, **characterized in that** the second contact part (116) can assume a defined first positional arrangement and at least one alternative second positional arrangement in the receptacle (124), wherein the first positional arrangement forms the first variant and wherein the alternative second positional arrangement forms the second variant such that the contact part (116) can be arranged, depending on the variant, in one of at least two different positions and/or in one of at least two different alignments, **characterized in that** the second contact part (116) comprises a synthetic material body (142) having embedded a first metal contact (144) and a second metal contact (146) for an electrical connection to the first and third contact parts (114, 118), and wherein the second metal contact (146) is arranged on a side of the synthetic material body (142) facing away from the first metal contact (144).

## Revendications

1. Dispositif de commande et/ou de régulation d'une installation technique (10), comportant un premier module de fond de panier (102), un deuxième module de fond de panier (104) et au moins un troisième module de fond de panier (106) qui peuvent être positionnés les uns à côté des autres sur un rail de support (128) définissant une direction longitudinale (L), dans lequel le premier module de fond de panier (102) possède un premier corps de base (108) et une première partie de contact (114), dans lequel le deuxième module de fond de panier (104) possède un deuxième corps de base (110) et une deuxième partie de contact (116), et dans lequel le troisième module de fond de panier (106) possède un troisième corps de base (112) et une troisième partie de contact (118), dans lequel les corps de base (108, 110, 112) comportent chacun une face supérieure (113) ayant des orifices d'insertion (122) dans lesquels les contacts électriques (134) de modules électroniques (126) séparés peuvent être introduits, et dans lequel les parties de contact (114, 116, 118) forment dans la direction longitudinale (L) une ligne de bus (120) par l'intermédiaire de laquelle les modules électroniques (126) embrochés peuvent être reliés électriquement les uns aux autres, dans lequel le deuxième corps de base (110) comporte un logement (124) dans lequel la deuxième partie de contact (116) est disposée de manière sélective selon une parmi au moins deux variantes définies, dans lequel, dans une première desdites deux variantes ou plus, la deuxième partie de contact (116) possède une liaison électriquement conductrice avec la première partie de contact (114) et avec la troisième partie de contact (118), et dans lequel, dans une deuxième desdites deux variantes ou plus, la deuxième partie de contact (116) possède une liaison électriquement conductrice avec la troisième partie de contact (118) mais pas avec la première partie de contact (114), dans lequel la deuxième partie de contact (116) peut être disposée dans une première pose et au moins une deuxième pose différente dans le réceptacle (124), dans lequel la première pose constitue la première variante et dans lequel la deuxième posse différente constitue la deuxième variante, de telle manière que la deuxième partie de contact (116) puisse être disposée en fonction des variantes à l'une d'au moins deux positions et/ou selon au moins deux orientations différentes, **caractérisé en ce que** la deuxième partie de contact (116) comporte un corps en matière plastique (142) dans lequel un premier contact métallique (144) et un deuxième contact métallique (146) sont reliés électriquement aux première et troisième parties de contact (114, 118), et dans lequel le deuxième contact métallique (146) est disposé sur un côté du corps en matière plastique (142) qui est tourné en sens opposé au premier contact métallique (144).

2. Dispositif selon la revendication 1, **caractérisé en ce que** les premier et troisième corps de base (108, 112) comportent respectivement un autre logement, dans lequel la première partie de contact (114) et la troisième partie de contact (118) sont respectivement disposées dans l'un des autres logements.

3. Dispositif selon la revendication 1 ou 2, **caractérisé par** une autre partie de contact (136) comportant un autre corps de base (138) et une autre partie de contact (140), dans lequel la troisième partie de contact (118) est variable par rapport à la deuxième partie de contact (116) et à l'autre partie de contact (140) de la même manière que la deuxième partie de contact (116) par rapport à la première partie de contact (114) et à la troisième partie de contact (118).

4. Dispositif selon l'une quelconque des revendications 1 à 3, **caractérisé par** un élément de verrouillage (130) au moyen duquel la deuxième partie de contact (116) peut être fixée dans le logement de manière sélective dans la première pose ou la deuxième pose.

5. Dispositif selon l'une quelconque des revendications 1 à 4, **caractérisé en ce que** la première pose est une première position spatiale de la deuxième partie de contact (116) dans le logement (124), et **en ce que** la deuxième pose est une deuxième position spatiale à laquelle la deuxième partie de contact (116) peut être délacée par un mouvement de translation.

6. Dispositif selon l'une quelconque des revendications 1 à 5, **caractérisé en ce que** la ligne de bus (120) comporte un certain nombre de premiers conducteurs (120b) et un certain nombre de deuxièmes conducteurs séparés (120a), dans lequel les premiers conducteurs (120b) forment un bus de données destiné à la transmission de données de commande, et dans lequel les deuxièmes conducteurs (120a) forment un rail de courant destiné à la distribution d'une tension d'alimentation, dans lequel les deuxièmes conducteurs (120a) passent à travers les parties de contact (114, 116, 118), tandis que les premiers conducteurs (120b) sont disposés de manière éloignée des parties de contact (114, 116, 118) dans les corps de base (108, 110, 112).

7. Dispositif selon l'une quelconque des revendications 1 à 6, **caractérisé en ce qu'**au moins la deuxième partie de contact (110) est disposée dans le logement (124) de manière à ce qu'elle puisse en être retirée de façon non destructive.

8. Dispositif selon l'une quelconque des revendications 1 à 7, **caractérisé en ce que** le deuxième corps de base (110) possède une largeur définie (B) dans la direction longitudinale, dans lequel la deuxième partie de contact (116) s'étend sensiblement sur ladite largeur définie.

9. Dispositif selon l'une quelconque des revendications 1 à 8, **caractérisé en ce qu'**au moins deux des corps de base (108, 110, 112) forment une unité structurelle intégrée.

10. Dispositif selon l'une quelconque des revendications 1 à 9, **caractérisé en ce que** la deuxième partie de contact (116) comporte un corps en matière plastique (142) qui est disposé entièrement à l'intérieur du logement (124).

11. Dispositif selon l'une quelconque des revendications 1 à 10, **caractérisé par** un premier et au moins un deuxième module électronique (126a, 126b) qui peuvent être embrochés de manière sélective sur le corps de base (108, 110, 112), dans lequel le premier module électronique (126a) comporte des premiers contacts électriques (134a) et dans lequel le deuxième module électronique (126b) comporte des deuxièmes contacts électriques, dans lequel les premiers contacts électriques (134a) sont réalisés de manière à ce que, selon la première variante, ils puissent être mis en contact électrique à l'état embroché, tandis que les deuxièmes contacts électriques sont réalisés de manière à ce que, selon la deuxième variante, ils ne puissent être mis en contact électrique à l'état embroché qu'avec la deuxième partie de contact (110).

12. Module de fond de panier destiné à être utilisé dans un dispositif selon l'une quelconque des revendications 1 à 11, comportant un corps de base qui présente une face supérieure (113) et au moins des première et deuxième surfaces latérales (148, 150), dans lequel la face supérieure (113) présente des orifices d'insertion (122) qui sont conçus pour la fixation mécanique et la mise en contact électrique d'un module électronique séparé (126), dans lequel la première surface latérale (148) est conçue pour être reliée mécaniquement à un premier module de fond de panier (102) du même type, et dans lequel la deuxième surface latérale (150) est conçue pour être reliée mécaniquement à un deuxième module de fond de panier (106) du même type et comprenant en outre au moins une partie de contact (116) comportant au moins un contact électrique (146) qui est conçu pour un raccordement électrique du premier ou du deuxième module de fond de panier du même type, et comportant un logement (124) dans lequel la partie de contact peut être positionnée de manière sélective selon l'une d'au moins deux variantes définies, dans lequel la partie de contact (116) peut être reliée de manière électriquement conductrice dans une première desdites deux variantes ou plus avec un premier module de fond de panier (102) d'un même type pouvant être relié mécaniquement à la première surface latérale et avec un deuxième module de fond de panier (106) du même type pouvant être relié à la deuxième surface latérale, et dans lequel la partie de contact (116), dans une deuxième desdites deux variantes ou plus, peut être reliée électriquement au deuxième module de fond de panier (106) du même type pouvant être relié à la deuxième surface latérale, mais pas avec le premier module de fond de panier (102) du même type pouvant être relié mécaniquement à la première surface latérale, **caractérisé en ce que** la partie de contact (116) peut être disposée dans une première pose et dans au moins une deuxième pose différente dans le réceptacle (124), dans lequel la première pose constitue la première variante et dans lequel la deuxième pose différente constitue la deuxième variante, de telle manière que la partie de contact (116) puisse être disposée en fonction des variantes à l'une d'au moins deux positions et/ou selon au moins deux orientations différentes, **caractérisé en ce que** la deuxième partie de contact (116) comporte un corps en matière plastique (142) dans lequel un premier contact métallique (144) et un deuxième contact métallique (146) sont reliés électriquement aux première et troisième parties de contact (114, 118), et dans lequel le deuxième contact métallique (146) est disposé sur un côté du corps en matière plastique (142) qui est tourné en sens opposé au premier contact métallique (144).
